Europäisches Patentamt

European Patent Office

Office européen des brevets

(11) Publication number: **0 338 706**
**A2**

## EUROPEAN PATENT APPLICATION

(21) Application number: **89303491.8**

(22) Date of filing: **10.04.89**

(51) Int. Cl.⁴: **H01L 21/00**

(30) Priority: **22.04.88 US 184780**

(43) Date of publication of application:
**25.10.89 Bulletin 89/43**

(84) Designated Contracting States:
**DE FR GB**

(71) Applicant: **CONTROL DATA CORPORATION**
**8100-34th Avenue South**
**Minneapolis Minnesota 55440(US)**

(72) Inventor: **Ries, Richard Dean**
**759 Cottage Avenue West**
**St. Paul Minnesota 55117(US)**
Inventor: **Smith, Dewey William**
**1062 Rice Creek Terrace**
**Fridley Minnesota 55432(US)**
Inventor: **Payton, Spero**
**1400 Quebec Avenue North**
**Golden Valley Minnesota 55427(US)**

(74) Representative: **Caro, William Egerton et al**
**J. MILLER & CO. Lincoln House 296-302 High**
**Holborn**
**London WC1V 7JH(GB)**

(54) A carrier assembly and a process for producing a carrier assembly for a semi-conductor package.

(57) A carrier assembly for releasably supporting a semi-conductor package (47) including a package body (44, 48) and a plurality of leads (50) extending from the body comprises a rigid carrier (82) having retaining means (118, 120) arranged for releasably securing the package against vertical movement relative to the carrier. Inter-connection means for attachment to the leads at the end portions thereof for substantially fixing the end portions with respect to one another are also provided and comprise two substantially identical dielectric frames (16, 46) positioned on opposite sides of the leads and fastened together with the leads therebetween. First registration means (34, 36) provided by the inter-connection means and second registration means (110, 112) provided by the carrier are positioned to engage one another to secure the inter-connection means against transverse movement relative to the carrier whereby to align the end portions of the leads of the semi-conductor package with respect to the carrier.

Fig. II

# A CARRIER ASSEMBLY AND A PROCESS FOR PRODUCING A CARRIER ASSEMBLY FOR A SEMI-CONDUCTOR PACKAGE

This invention relates to a carrier assembly and to a process for producing a carrier assembly for a semi-conductor package having a package body and multiple electrically conductive leads extending from the body.

Semi-conductor packages are frequently mounted in protective carriers for protection against mechanical damage during shipping and handling, and also for proper alignment of the package, and in particular its conductive leads, relative to electrical hardware during electrical testing.

One known technique for accurately aligning a semi-conductor package within a protective carrier is to form the carrier with multiple parallel ribs or rises and to dispose each lead of the package between a pair of adjacent parallel ribs or rises. With the leads so positioned, the package is accurately aligned with respect to the carrier. For a typical package including a rectangular package body and leads projecting outwardly from the body's sides, the ribs secure the package against movement parallel to the major plane of the package, i.e. in the directions of mutually perpendicular X and Y axes. A spring loaded beak, latch, snap-on lid or other retainer is then used to secure the package in the direction of a Z axis orthogonal to the major plane.

Due to the generally poor tolerances associated with the body of the semi-conductor package, the body cannot itself be used to align the package in the directions of the X and Y axes. Rather, the ribs or rises of the carrier provide the mechanical means by which the package is located in these directions. A problem with this arrangement, however, is that only those ribs or rises which are in actual contact with the package leads directly prevent the entire semi-conductor package from moving significantly in the direction of either the X or the Y axis. If the carrier and package experience a sudden impact during handling or shipping, the ribs or rises prevent the leads from significant movement but the semi-conductor package body, because of its typically poor dimensional tolerances, is not restricted from movement. Consequently, damage to or bending of the package leads can result, and this may adversely affect the true position of the leads and subsequent manufacturing operations.

Therefore, it is an object of the present invention to provide a means for aligning a semi-conductor package and a carrier without the need for providing lead positioning ribs on the carrier.

According to a first aspect of the invention, there is provided a carrier assembly for releasably supporting a semi-conductor package including a package body and a plurality of leads extending from the body, the carrier assembly comprising a rigid carrier having retaining means arranged for releasably securing a semi-conductor package against vertical movement relative to the carrier, and being characterised by inter-connection means for attachment to the leads of the semi-conductor package at the end portions thereof for substantially fixing the end portions with respect to one another, and a first registration means provided by the inter-connection means and a second registration means provided by the carrier, the first and second registration means being positioned to engage one another to secure the inter-connection means against transverse movement relative to the carrier whereby to align the end portions of the leads with respect to the carrier.

As described below, the inter-connection means may comprise a non-conductive tie bar, for example as disclosed in the Applicants' European Patent Application No. 88306303.4.

Preferably, the carrier is constructed of a dielectric material, and has a surface arranged to engage the leads of the semi-conductor package when the package is mounted in the carrier. Thus, the carrier may support and protect the leads whilst still permitting electrical testing. Typically, for a substantially flat and rectangular package body comprising a member with leads extending from all sides in a major plane of the package body, the surface of the carrier may also be planar.

The inter-connection means preferably includes a rectangular dielectric frame assembly. The registration means can then comprise circular openings formed at opposite corners of the dieletric frame, and a pair of pins projecting from the carrier, one corresponding to each opening. Advantageously, the dielectric frame assembly includes two dielectric frames, for mounting one on each side of the leads with an adhesive joining the frames to the leads and/or to each other with the leads therebetween. This "sandwich" construction encloses the leads, and may also enclose sheet metal members at opposite corners of the frame assembly, these members providing a more durable structure defining the registration openings.

Another aspect of the present invention features a process for producing an assembly comprising a carrier and a semi-conductor package releasably mounted on the carrier, characterised by the steps of providing a semi-conductor package having a package body, a plurality of electrically conductive leads extending outwardly from the package body, and an electrically conductive frame attached to end portions of the leads remote from the package body; forming at least one registration opening through the conductive frame at a selected location thereof; providing a dielectric frame; forming at least one alignment opening through the dielectric frame; fastening the dielectric frame to the leads of the semi-conductor package in a position such that the at least one alignment opening is aligned with the at least one registration opening; removing portions of the conductive frame to isolate the selected location from the leads; providing a rigid carrier having releasable retaining means and at least one registration pin; and releasably mounting the semi-conductor package and the dielectric frame on the rigid carrier with the retaining means engaging the package body and the at least one registration pin engaged within the at least one registration opening.

The use of this process permits highly accurate positioning of the or each registration opening relative to the leads, due to the initial fixed relationship between the leads and the conductive frame. The dielectric frame is attached to the end portions of the leads with the conductive frame still intact, thereby preserving the positional relationship between the leads and the or each registration opening. Later, when portions of the conductive frame are removed in order to isolate the leads electrically, the dielectric frame maintains the desired relationship between the or each registration opening and the leads.

Accordingly, the invention also provides a process for forming a dielectric connection of the leads of an integrated circuit package initially having an electrically conductive lead inter-connection, and for later removing the conductive inter-connection to isolate the leads electrically.

The invention will be described further, by way of example, with reference to the accompanying drawings, in which:

Figure 1 is a top view of a dielectric frame for use in a semi-conductor package assembly;

Figure 2 is a edge view of the frame of Figure 1;

Figure 3 is a top view of a semi-conductor package assembled with the dielectric frame;

Figure 4 is an edge view of the assembly of Figure 3;

Figure 5 is a top view of a carrier for releasably supporting the assembly of the semi-conductor package and the dielectric frame;

Figure 6 is a bottom view of the carrier;

Figure 7 is an end view of the carrier;

Figure 8 is a sectional view taken along the line 8 - 8 in Figure 6;

Figure 9 is an enlarged side view of a retainer of the carrier;

Figure 10 is an end view of the retainer; and

Figure 11 is a top view of the assembly of the semi-conductor package and the dielectric frame mounted on the carrier.

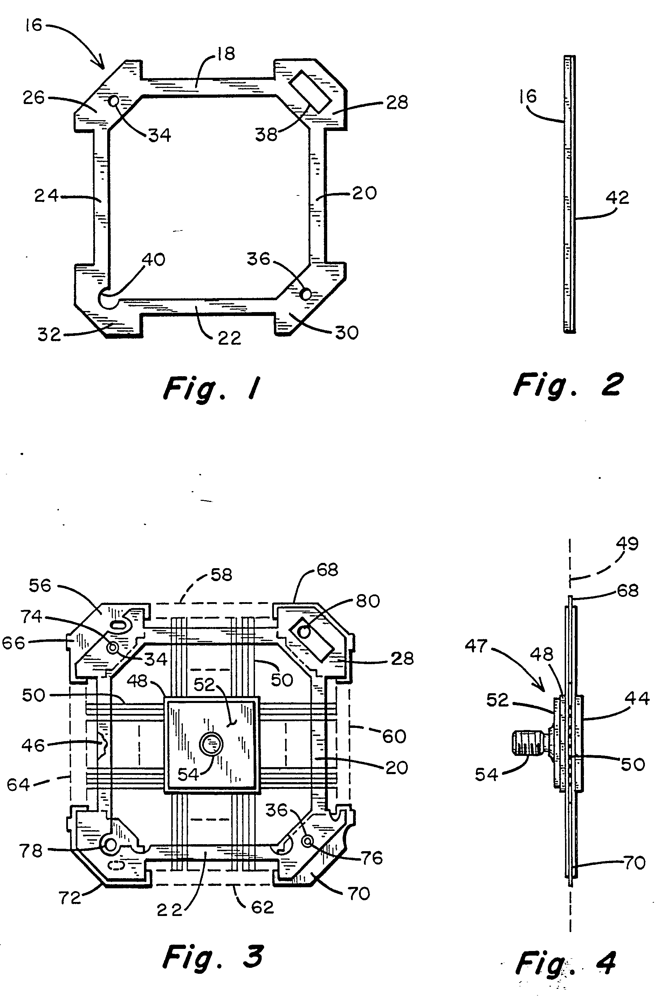

Referring to the drawings, Figure 1 shows a dielectric frame 16 suitable for the releasable mounting of a semi-conductor package in accordance with the present invention. The frame 16 is preferably formed from a glass fibre filled epoxy resin, polyimide or other suitable material to provide a substantially rigid, although not brittle, non-conductive support. The frame 16 is essentially rectangular, including four tie bars 18, 20, 22, and 24 disposed for connection to the leads of a semi-conductor package, and enlarged corners 26, 28, 30 and 32. Alignment apertures 34 and 36 are formed respectively in the diagonally opposite corners 26 and 30. A rectangular opening 38 is formed in the corner 28, and a cut out 40 is formed in the diagonally opposite corner 32. The dielectric frame 16 is coated on one surface with an adhesive 42, preferrably a high temperature acrylic adhesive.

Figures 3 and 4 illustrate a semi-conductor package 47 mounted in a non-conductive support including the dielectric frame 16 and a second dielectric frame 46, substantially identical to the frame 16 and disposed behind the frame 16 and in alignment with it as viewed in Figure 3. The semi-conductor package includes a centrally located package body consisting of an alumina base 48 and an alumina cap 44, both of which are generally flat and rectangular and which define a major plane represented by the broken line 49 in Figure 4. The base 48 and the cap 44 are joined together to enclose an integrated circuit chip. A plurality of fine, electrically conductive leads 50 extend outwardly from all four sides of the package body within the major planes. A stud 54 projects outwardly from the package body in a direction normal to the major plane and is attached to a heat spreader 52, which in turn is attached to the base 48.

Prior to their attachement to the dielectric frames 16 and 46, the leads 50 are supported at their ends remote from the package body by a conductive frame 56. The frame 56 initially includes conductive tie bars 58, 60, 62 and 64, indicated by broken lines and connected as shown to the remote ends of the leads 50, and enlarged conductive corner regions 66, 68, 70 and 72. Typically, the conductive frame is formed of the same conductive material as the leads 50, e.g. a nickel and gold plated metal alloy, with leads 50 and the frame 56 (including the corner regions) formed as a single etching, stamping or the like. Two registration openings 74 and 76 are formed through the corner regions 66 and 70, respectively. An opening 78 is formed through the corner region 72, which an offset opening 80 formed in the corner region 68. Each of the openings 74 to 80 is selectively and precisely positioned with respect to the leads 50, since these openings are formed in the original etching or stamping process.

In accordance with the present invention, the dielectric frames 16 and 46 are fastened to the remote end portions of the leads 50 in lieu of the conductive frame 56, while retaining the selected and precise positioning of the conductive corner regions 66 to 72 with respect to the leads 50. In particular, with the conductive tie bars 58 to 64 still forming a part of the conductive frame 56 and still being connected to the remote ends of the leads 50, the dielectric frames 16 and 46, coated with the adhesive 42, are positioned on opposite sides of the conductive frame 56 such that the openings through each dielectric frame 16, 46 and the corresponding openings through the conductive frame 56 are aligned as shown in Figure 3. Then, with the adhesive and remote end portions of the leads 50 between them, the frames 16 and 46 are forced against the leads and against one another under pressure. If desired, the adhesive 42 could also be heat sensitive and/or ultra-violet light sensitive, in which case pressure, heat and ultra-violet light or any combination thereof could be used to cure or set the adhesive. As a result, the leads 50, particularly at their remote end portions, are firmly secured with respect to the dielectric frames 16 and 46.

At this point, the conductive tie bars 58 to 64 are cut away from the frame 56 leaving only the corner regions as illustrated in Figure 3. Preferably, the conductive tie bars and the associated dielectric tie bars are spaced apart from one another, so that the removal of each conductive tie bar leaves the remote ends of the leads 50 exposed beyond the dielectric frames 16 and 46.

With the conductive tie bars 58 to 64 removed, the dielectric tie bars 18 to 24 effectively take the place of the conductive tie bars in securing the remote ends of the leads 50 fixedly with respect to one another, thus preserving a desired spacing between adjacent leads. Moreover, the dielectric frames 16 and 46 are fixedly secured to the corner regions 66 to 72 by virtue of the adhesive, thus preserving the desired alignment of the leads 50 with the openings formed through the original conductive frame, particularly the registration openings 74 and 76. As indicated in Figure 3, the alignment apertures 34 and 36 are slightly larger than their associated registration openings 74 and 76. This reduces the need for absolute accuracy in aligning the dielectric frames 16 and 46 with the conductive frame 56, and ensures that the positioning of the semi-conductor package 47 with respect to a carrier (as described below) depends upon the registration openings 74, 76 rather than the alignment apertures 34, 36.

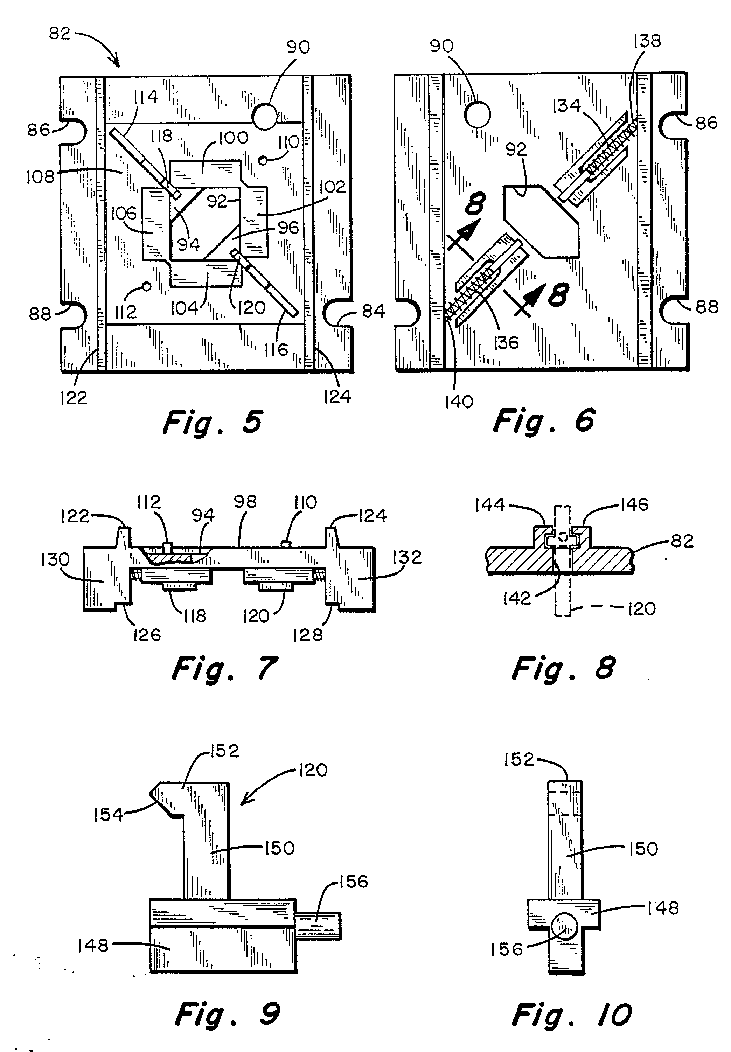

Figures 5 to 7 illustrate a carrier 82 particularly well suited for transporting and handling the semi-conductor package 47, and for positioning the package for electrical testing. The carrier 82 is preferably constructed from a substantially rigid (e.g. glass filled) dielectric material, for example a plastics material such as polyethersulfone (PES), polyphenylene sulfide, nylon, polyetherimide (PEI), polyamide-imide, polycarbonate and polyester. Preferably, the material for the carrier 82 should be able to withstand temperature cycling over a wide range, for example from -55°C to 125°C. The resistance per square of the carrier sheet is typically $10^{10}$ to $10^{13}$ ohms, although the actual optimum value depends upon the nature of the integrated circuit chip. Alternatively, if a dielectric frame is disposed between the leads 50 and the carrier 82 or if no electrical testing is contemplated, the carrier can be constructed from aluminium or other metals. The carrier 82 is rectangular, and includes a plurality of alignment grooves 84, 86 and 88, which co-operate with a carrier alignment hole 90 to align the position of the carrier 82, and thus align the semi-conductor package 47 when mounted in the carrier, with respect to an electrical testing socket (not shown).

A central opening 92 is formed through the carrier 82 and is sufficiently large to accommodate the semi-conductor package body. A pair of triangular shelves 94 and 96, formed at opposite corners of the opening 92, provide a horizontal stop to prevent excessive downward deflection of the semi-conductor package during handling, shipping or testing. These triangular shelves are parallel to and recessed below a top surface 98 of the carrier.

Immediately surrounding the opening 92 are four raised portions 100, 102, 104 and 106, which together provide a raised surface substantially in the plane of the top surface 98. When the semi-conductor package 47 is mounted in the carrier 82, the package leads 50 rest upon the raised portions 100 to 106. A recess or trough 108 is formed outwardly of and surrounding the raised portions 100 to 106 in order to accommodate the lower dielectric frame 46.

A pair of cylindrical registration pins 110 and 112 extend vertically upwardly from the recess 108. The pins 110 and 112 have a uniform circular profile, with a diameter just slightly less than the diameter of the registration openings 74 and 76.

A pair of diagonally disposed channels 114 and 116 formed through the carrier 82 extend away from the central opening 92 within the recess 108. The channel 114 supports a retainer 118 for diagonal sliding movement towards and away from the central opening 92, and the channel 116 similarly supports an opposite retainer 120. A pair of parallel ribs 122 and 124 provided near opposite sides of the carrier 82, project upwardly from the top surface 98. Directly below the ribs and aligned with them are opposed cut outs 126 and 128, each formed in the bottom of one of two legs 130 and 132 of the carrier. The alignment of the ribs and cut outs affords a convenient means for stable stacking of multiple carriers.

As shown in Figure 6, the retainers 118 and 120 extend beneath the respective channels 114 and 116. Each retainer, 118, 120 is biased towards the opening 92 by a coil spring 134, 136 respectively. A pair of rods 138 and 140 are disposed diagonally of the central opening 92, each being surrounded by an outer end portion of a respective one of the coil springs.

Figures 8 to 10 illustrate the retainer 120 in greater detail, along with its mounting within the channel 116. It is to be understood that the retainer 118 is substantially similar, as is the nature of its mounting within the channel 114. Considering first Figure 8, the channel 116 includes an elongate slot 142 formed within the carrier recess 108, and a widened portion defined by a pair of opposed, L-shaped legs 144 and 146, which extend downwardly from the carrier (but appear to extend upwardly in Figure 8 as this Figure is inverted). The retainer 120, as shown in broken lines, extends outwardly from the slot 142 in both vertical directions.

As shown in Figures 9 and 10, the retainer 120 includes a T-shaped body 148, a leg 150 extending vertically upwardly from the body, and a beak or head 152 including an inclined surface 154 adapted for contact with the heat spreader 52 when the semi-conductor package 47 is mounted in the carrier. A rod 156 extends horizontally from the body 148, and is surrounded by an inner end portion of the coil spring 136, thereby co-operating with the rod 140 to retain the spring in place. A portion of the wall of the carrier 82 surrounding the central opening 92 limits the travel of each retainer under the action of its associated coil spring.

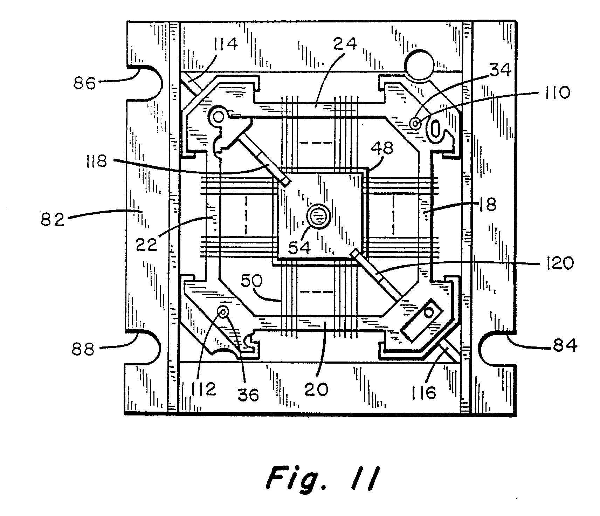

The mounting of the semi-conductor package 47 on the carrier 82 is illustrated in Figure 11. The mounting is conveniently accomplished automatically or by hand, by removing the retainers 118 and 120 diagonally away from the opening 92 to admit the package body into the opening, while selectively positioning the corner regions 66 and 70 so that their respective registration openings 74 and 76 receive the pins 110 and 112. The close fit of the registration pins within the registration openings substantially prevents any movement of the dielectric frame assembly in any horizontal or transverse direction (i.e. in the direction of the X and Y axes) with respect to the carrier 82. The remote end portions of the leads, being fixedly attached to the tie bars 18 to 24 provided by the dielectric frames 16 and 46, are likewise secured against such movement. The lead ends are thus positionally aligned with the carrier 82, and therefore also with any electrical testing equipment with which the carrier is aligned. While a single registration opening and pin of non-circular profile might be marginally adequate for determining the alignment of the carrier in the directions of the X and Y axes, the opposed pair as disclosed is preferable. Of course, three or more registration pins and openings can be employed.

The retainers 118 and 120, urged towards one another by the coil springs 134 and 136, engage the package body along their inclined surfaces 154 to urge the semi-conductor package 47 downwardly and thereby to position the leads 50 against the raised portions 100 to 106, so as to secure the semi-conductor package firmly in a vertical direction, or direction of the Z axis, as well. Situated between the dielectric frames and the package body, the raised portions 100 to 106 are thus contiguous with the leads 50 so as to protect them from damage and support and position them in the vertical direction of the Z axis for electrical testing.

A feature of the present invention is that the leads 50 act in concert to support the dielectric frames and the semi-conductor package body substantially integrally relative to one another. The shock from any sudden impact upon the carrier 82 is transferred to this semi-conductor package assembly from the registration pins at their associated corner regions, which are remote from the leads 50 and the package body. The shock then travels along the remainder of the assembly, where it is substantially absorbed before reaching the leads and the semi-conductor package body. This arrangement ensures that no individual lead is isolated to bear a dis-proportionate share of the shock, which protects the leads against damage more effectively than the aforementioned conventional ribs. Moreover, in replacing such ribs with the essentially flat and horizontal raised surface provided by the raised portions 100 to 106, a carrier constructed in accordance with the present invention can releasably and interchangeably support semi-conductor packages having different numbers of leads, different spacings between adjacent leads, and different lead orientations.

Accordingly, the described arrangement provides means for mounting an integrated circuit package and a carrier, in which forces due to any sudden impact are distributed substantially to non-critical locations or features which do not affect the package lead true position or result in damage to the package leads.

In addition, the described arrangement provides a means for accurately aligning an integrated circuit package relative to a carrier, while electrically isolating the leads from one another to permit electrical testing of the package while mounted on the carrier. A carrier assembly constructed as described positively aligns the semiconductor package and carrier, which allows alignment of the package for testing and the like simply by aligning the carrier. In contrast to the known approach utilising ribs, the force of any sudden impact or jostling is absorbed by the metal sheets in the opposite corners of the package assembly, the adhesive between the sheets and dielectric frames, and the frames themselves - rather than directly by the leads. This eliminates the interaction of any particular lead with the carrier, thus removing the potential for lead damage. The presence of the metal sheets possessing the registration openings ensures a more precise, reliable and repeatable positioning of the package and carrier. Finally, when circular openings and pins are used for registration, and the openings are positioned at opposed corners of a rectangular dielectric frame or pair of frames, minimal force is required to resist rotation of the package relative to the carrier, further enhancing the security of the connection.

## Claims

1. A carrier assembly for releasably supporting a semi-conductor package including a package body and a plurality of leads extending from the body, the carrier assembly comprising a rigid carrier (82) having retaining means (118, 120) arranged for releasably securing a semi-conductor package against vertical movement relative to the carrier, and being characterised by inter-connection means (16) for attachment to the leads of the semiconductor package at the end portions thereof for substantially fixing the end portions with respect to one another, and a first registration means (34, 36) provided by the inter-connection means and a second registration means (110, 112) provided by the carrier, the first and second registration means being positioned to engage one another to secure the inter-connection means against transverse movement relative to the carrier whereby to align the end portions of the leads with respect to the carrier.

2. An assembly according to claim 1, characterised in that the carrier and the inter-connection means are constructed substantially of dielectric materials, and in that the carrier has a surface (100, 102, 104, 106) positioned to engage the leads of a semi-conductor package and thereby to co-operate with the retaining means for securing the semi-conductor package.

3. An assembly according to claim 2, characterised in that the surface is substantially planar for engaging the leads in a plane.

4. An assembly according to any of claims 1 to 3 characterised in that the first registration means comprises a registration opening formed through the inter-connection means, and in that the second registration means comprises a pin integral with the carrier, the pin having a profile corresponding to the shape of the registration opening whereby the pin when extending through the registration opening tends to align the inter-connection means relative to the carrier.

5. An assembly according to any of claims 1 to 3 characterised in that the first registration means comprises a plurality of registration openings formed through the inter-connection means, and in that the second registration means comprises a plurality of pins integral with the carrier, each of the pins being associated with a respective one of the registration openings and having a profile corresponding to the shape of the associated registration openings whereby the pins when extending through the associated registration openings tend to align the inter-connection means relative to the carrier.

6. An assembly according to any preceding claim characterised in that the inter-connection means comprises a frame for surrounding the semi-conductor package.

7. An assembly according to claim 6 characterised in that the inter-connection means comprises a further frame (46) similar to the first frame, and adhesive means (42) for securing the two frames with the leads of the semi-conductor package therebetween.

8. An assembly according to claim 7 characterised in that the first and further frames are rectangular and in that the first registration means are provided at opposite corners thereof.

9. An assembly according to claim 7 or 8 characterised in that metallic sheet members (66, 68, 70, 72) are provided for attachment between the first and further frames at the opposite corners, and in that the first registration means are provided by the metallic sheet members.

10. A carrier according to any preceding claim characterised in that the retaining means comprise first and second channels (114, 116) formed in a portion (108) of the carrier, first and second retaining members (118, 120) mounted in the first and second channels respectively for linear movement towards and away from a central region of the carrier, and biasing means (134, 136) for urging the first and second retaining members towards the central region whereby to cause the retaining members to engage the semi-conductor package body when the body is positioned at the central region so as to locate the body relative to the carrier.

11. An assembly according to claim 10 characterised in that each of the retaining members comprises a retainer body (148) slidable within the associated channel, a leg (150) extending from the retainer body, and a beak (152) extending from one end of the leg, the beak having an inclined surface (154) positioned to engage the package body.

12. An assembly according to any preceding claim in combination with a semi-conductor package (47).

13. A carrier for use in an assembly according to any preceding claim, the carrier being characterised by a rigid support (82), retaining means (118, 120) arranged for releasably securing a semi-conductor package against movement in a direction vertically of the rigid support, and registration means (110, 112) for engagement with corresponding registration means provided by means attached to leads of the semi-conductor package.

14. A process for producing an assembly comprising a carrier (82) and a semi-conductor package (47) releasably mounted on the carrier, characterised by the steps of providing a semi-conductor package (47) having a package body (44, 48), a plurality of electrically conductive leads (50) extending outwardly from the package body, and an electrically conductive frame (56) attached to end portions of the leads remote from the package body; forming at least one registration opening (74, 76) through the conductive frame at a selected location thereof; providing a dielectric frame (16); forming at least one alignment opening (34, 36) through the dielectric frame; fastening the dielectric frame to the leads of the semi-conductor package in a position such that the at least one alignment opening is aligned with the at least one registration opening; removing portions (58, 60, 62, 64) of the conductive frame to isolate the selected location from the leads; providing a rigid carrier (82) having releasable retaining means (118, 120) and at least one registration pin (110, 112); and releasably mounting the semi-conductor package and the dielectric frame on the rigid carrier with the retaining means engaging the package body and the at least one registration pin engaged within the at least one registration opening.

15. A process according to claim 14 characterised by the further steps of providing a second dielectric frame (46); forming at least one second alignment opening (34, 36) through the second dielectric frame; and prior to removing the portions of the conductive frame, fastening the second dielectric frame to the first dielectric frame with the leads and the conductive frame positioned therebetween and with the at least one second alignment opening aligned with the at least one first alignment opening.

16. A process according to claim 15 characterised in that the at least one first alignment opening, the at least one second alignment opening, and the at least one registration opening are circular with the alignment openings being slightly larger in diameter than the at least one registration opening.

17. A process according to claim 15 or 16 characterised in that the fastening of the second dielectric frame to the first dielectric frame is achieved by utilising a pressure sensitive adhesive (42), and by pressing the dielectric frames towards one another with the adhesive therebetween.

18. A process for manufacturing an assembly comprising a carrier and a leaded semi-conductor package releasably mounted on the carrier, characterised by the steps of providing a leaded semi-conductor package (47) including a package body (44, 48), a plurality of electrically conductive leads (50) extending outwardly from the package body, and an electrically conductive frame (56) attached to end portions of the leads remote from the package body; forming a pair of registration openings (74, 76) through the conductive frame at first and second select locations thereon; forming a pair of first alignment openings (34, 36) through a first dielectric frame (16); fastening the first dielectric frame to the leads in a select position to align each first alignment opening with one of the registration openings; and removing portions of the conductive frame other than the select locations, whereby the select locations are integrally supported with respect to the end portions of the leads by the first dielectric frame and are electrically isolated from the leads.

*Fig. 1*

*Fig. 2*

*Fig. 3*

*Fig. 4*

Fig. 5

Fig. 6

Fig. 7

Fig. 8

Fig. 9

Fig. 10

*Fig. 11*